(19) Europäisches Patentamt
European Patent Office
Office européen des brevets

(11) EP 0 663 671 B1

(12) EUROPEAN PATENT SPECIFICATION

(45) Date of publication and mention
of the grant of the patent:
**22.07.1998 Bulletin 1998/30**

(51) Int Cl.$^6$: **G21K 1/14**, H05H 3/02

(21) Application number: 94120961.1

(22) Date of filing: **30.12.1994**

(54) **Beam charge exchanging apparatus**

Strahlladungsaustauschvorrichtung

Dispositif pour l'échange de charges d'un faisceau

(84) Designated Contracting States:
**DE FR GB**

(30) Priority: **13.01.1994 JP 14861/94**
**14.04.1994 JP 100579/94**

(43) Date of publication of application:
**19.07.1995 Bulletin 1995/29**

(73) Proprietor: **EBARA CORPORATION**
**Ohta-ku, Tokyo (JP)**

(72) Inventors:
• **Saito, Mutsumi**
**Fujisawa-shi, Kanagawa-ken (JP)**
• **Yahiro, Tomoyuki**
**Fujisawa-shi, Kanagawa-ken (JP)**
• **Hatakeyama, Masahiro**
**Fujisawa-shi, Kanagawa-ken (JP)**

(74) Representative:
**Geyer, Ulrich F., Dr. Dipl.-Phys. et al**
**WAGNER & GEYER,**
**Patentanwälte,**
**Gewürzmühlstrasse 5**
**80538 München (DE)**

(56) References cited:
**GB-A- 2 008 310        US-A- 4 092 534**
**US-A- 4 549 082**

• **PATENT ABSTRACTS OF JAPAN vol. 007 no.**
**162 (E-187), 15 July 1958 & JP-A-58 071 548**
**(NIPPON DENSHI KK) 28 April 1983,**
• **PROCEEDINGS OF THE 11TH SYMPOSIUM ON**
**FUSION ENGINEERING, vol. 1, AUSTIN, TEXAS**
**- 18/22 NOV. 1985, pages 176-179, J. VETROVEC:**
**'Gas jet neutralizer for MFTF-B pure beam**
**injectors'**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

## Description

This invention relates to a beam charge exchanging apparatus for exchanging the charge of a fast charged particle beam such as an ion beam so as to change it into a neutral particle beam, the apparatus being employed in the manufacture of semiconductors or the like.

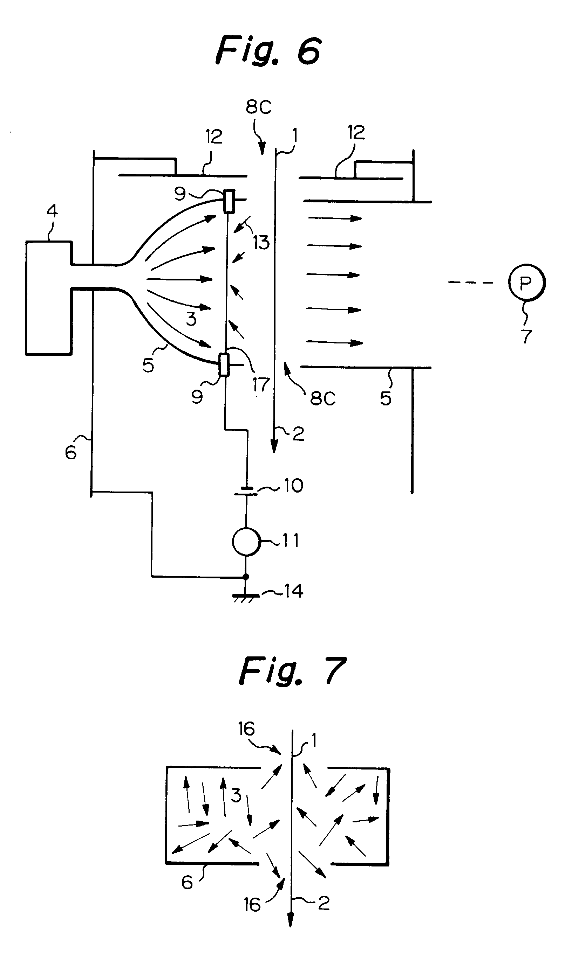

Conventionally, an apparatus shown in Fig. 7, which is known as a gas cell has been widely used as this type of charge exchanging apparatus. The gas cell includes a gas container 6, which is placed in a vacuum container and includes holes 16 through which a charged particle beam is passed. A charged particle beam 1 is passed through the gas container 6 to bring it into collision with a gas 3, which is introduced in the gas container through a gas introducing pipe (not shown), thereby exchanging the charges between the charged particle beam and the gas. There is another conventional apparatus called a metallic vapor cell which employs, an alkaline metallic vapor such as Li as a gas for the cell. In this apparatus, the charged particle beam 1 is passed through the vapor so as to cause the charged particle to collide with the metallic vapor, thereby exchanging the charge therebetween.

In the conventional gas cell, however, since gas 3 is introduced into the gas container 6 located in the vacuum container; the holes 16 of the gas container 6 should be made small to prevent the vacuum from deteriorating due to the diffusion of gas from the gas cell. For this reason, it has been impossible to obtain many gas particles or charged particles in the gas cell.

The metallic vapor cell has a similar drawback as in the gas cell, in that the quantity of beams introduced in the container is restricted to maintain a vacuum level and further the container body is damaged by the chemically active alkaline metal.

According to the charge neutralizing method based on a molecular beam disclosed in Japanese Patent Laid Open No. 5-129096 which has recently been opened to the public, the charge exchanging efficiency is low because the number of molecules is limited and, therefore, it is difficult to accomplish the charge exchange of a large quantity of beams. Furthermore, according to the aforesaid method, when a large quantity of ion beams are changed into neutral beams, it unavoidably involves a large sized apparatus. Hence, it has been difficult to obtain high-energy neutral particle beams effectively, and the highest possible energy value is limited to a few KeV.

Further, attention is drawn to the Proceedings of the 11th symposium on fusion engineering, vol. 1, Austin, Texas - 18/22 Nov. 1985, pages 176-179, J. VETROVEC "Gas jet neutralizer for MFTF-B pure beam injectors", where a gas jet neutralizer is described. The described neutralizer comprises a nozzle and a skimmer for introducing the gas jet into a vacuum chamber, for collision with a beam which is passed through said chamber.

Furthermore, in the conventional charge exchanging apparatus, there was no means for immediately measuring the quantity of neutral particles after charge exchange.

Therefore, this invention has been made to solve the above problems, and it is an object of the present invention to provide an apparatus which is capable of exchanging the charges of a large quantity of high-energy beams with high efficiency.

It is an another object of the present invention to provide an apparatus which is capable of exchanging the charges of a large quantity of high-energy beams with high efficiency and of measuring the quantity of obtained neutral particles.

In order to accomplish the first object, an apparatus as set forth in claim 1 is provided. Prefered embodiments of the invention are claimed in the dependent claims.

In order to accomplish the second object, an apparatus according to the present invention is constituted as a beam charge exchanging apparatus for exchanging the charges of charged particles in a fast particle beam emitted from a source of the fast particle beam comprising; a gas container for beam exchange placed in a vacuum atmosphere; holes provided in said container for passing said fast particle beam through said container; a source of gas; means for introducing said gas in said container as a high speed gas fluid; wherein said charged fast particle beam collides with said high speed gas fluid in said container for exchanging charges therebetween and turning said fast particle beam to a neutral particle beam; said apparatus further includes means for detecting the quantity of neutral particles resulting from said charge exchange by detecting the quantity of ionized gas generated in said high speed gas fluid as an electric current.

In the apparatus according to the invention arranged as above, a charged particle beam is passed through a high speed gas fluid having directivity in the container for charge exchange so as to change an ion particle beam into a neutral particle beam. Therefore, a problem in which the high speed gas fluid diffusing out of the container through the holes can be prevented. Hence, it is possible to make the holes of the container larger to increase the area of contact between the gas fluid and the charged particle beam within the container, thereby highly efficient charge exchange can be achieved, leading to the accomplishment of higher energy beams.

In the process where the charged particle beam is passed through a high speed gas fluid for charge exchange, the high speed gas fluid obtains surplus charges resulting from the charge exchange. Accordingly, the high speed gas fluid is charged by the quantity of the charges resulting from the charge exchange and ionized. The ionized gas fluid can be collected on an ion capturing electrode and the quantity of ions in the gas fluid can be measured by measuring the current value, thus enabling the measurement of the quantity of the neutral particles in the neutral beam obtained by charge exchange.

The above and other objects, features and advantages of the present invention will become more apparent from the following description when taken in conjunction with the accompanying drawings in which preferred embodiments of the present invention are shown by way of illustrative examples.

Fig. 1 is a diagram illustrating a beam charge-exchanging apparatus of an embodiment according to the present invention wherein a divergent nozzle is provided with holes through which beams pass;

Fig. 2 is a diagram illustrating a beam charge-exchanging apparatus of a second embodiment of the invention wherein a gas fluid is turned into a free jet through a nozzle of a reservoir tank;

Fig. 3 is a diagram illustrating a beam charge-exchanging apparatus of a third embodiment of the invention wherein a divergent nozzle is provided in the container;

Fig. 4 is a diagram illustrating a beam charge exchanging apparatus of a fourth embodiment according to the present invention, wherein holes through which beams pass are provided in the middle of a divergent nozzle and beam quantity measuring means is incorporated;

Fig. 5 is a diagram illustrating a beam charge exchanging apparatus of a fifth embodiment according to the present invention, wherein a gas fluid is turned into a free jet through a nozzle of a reservoir tank, and beam quantity measuring means is incorporated;

Fig. 6 is a diagram illustrating a charge exchanging apparatus of a sixth embodiment according to the present invention, wherein a divergent nozzle is provided in the container, and beam quantity measuring means is incorporated; and

Fig. 7 is a diagram illustrating a conventional beam charge exchanging apparatus.

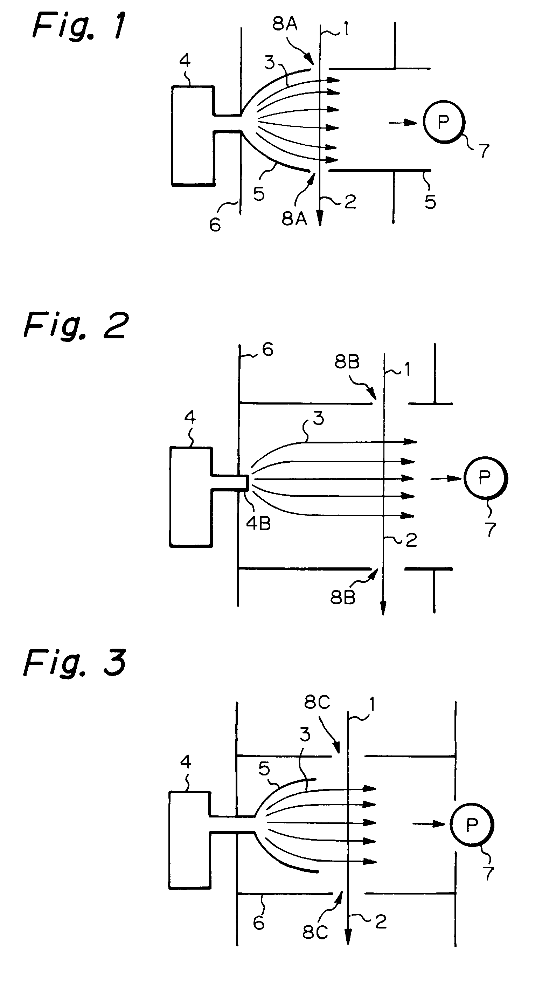

Figs. 1 to 3 respectively show examples of a beam charge exchanging apparatus to which the present invention is applied. Reference numeral 1 denotes an ion beam before charge exchange; reference numeral 2 denotes a neutral particle beam after charge exchange; reference numeral 3 denotes a high speed fluid such as a gas which comes in contact with the beam 1 before charge exchange for charge exchange; and reference numeral 4 denotes a reservoir tank of the gas 3. Reference numeral 5 denotes a divergent nozzle which turns the gas 3 into a supersonic stream and turns the speed component of the gas 3 into a component which is perpendicular to the beam 1; reference numeral 6 denotes a gas container of the beam charge exchanging apparatus; and reference numeral 7 denotes a vacuum pump which exhausts the gas 3 coming out of the nozzle 5 or container 6. By selecting a proper shape of the nozzle 5 and a proper gas pressure for the reservoir tank 4, the gas 3 emitted from the nozzle 5 can be made supersonic the speed component of which is not directed to the holes 8 and therefore become less liable to exit through the holes 8 in the container 6 through which the beams 1 and 2 pass, thus making it possible to make a difference in pressure great between the inside and the outside of the container 6.

Fig. 1 shows the gas divergent nozzle 5 which has, at the middle thereof, holes 8A through which the beams 1 and 2 pass. This structure allows the charged particle (ion) beam 1 to pass through a gas fluid from the gas reservoir tank 4 which has been expanded and accelerated via the gas nozzle 5 so as to exchange the charge and turn the charged particle beam 1 into the neutral particle beam 2.

Fig. 2 shows the gas fluid provided as a free jet in the container 6 through the nozzle 4B of the gas reservoir tank 4. Holes 8B through which the beams 1 and 2 pass are provided in the top and bottom surfaces of the container 6. This structure allows the charged particle (ion) beam 1 to pass through the holes 8B of the container 6 and go through the high speed gas fluid, which has turned into the free jet through a nozzle 4B of the gas reservoir tank, so as to exchange the charge and turn the charged particle beam 1 into the neutral particle beam 2.

The apparatus shown in Fig. 3 has the gas divergent nozzle 5 provided in the container 6; charge exchange is performed between the gas fluid, which has been expanded and accelerated, and the charged particle beam 1 which enters through a hole 8C of the container 6 to produce the neutral particle beam 2 which exits through another hole 8C.

Now, for example, in the embodiments shown in Figs. 1 and 3, if it is assumed that the cross-sectional area of the converged section of the nozzle is denoted by S1 and the area of the diverged section of the nozzle is denoted by S2; and

$$S2/S1 = 30$$

If the pressure of the reservoir tank 4 is 1300 Pa and the gas is Ar, then the Ar gas is released from the nozzle 5 as a supersonic jet of approximately Mach 7 which has a pressure of 0.74 Pa and which has linear directivity in the container 6. Thus, the Ar gas 3 collides with the ion beam 1 so that the charge exchange is performed therebetween, and it is then exhausted out of the container 6 by the vacuum pump 7. This structure provides the advantage of a high probability of successful collision between the ion beam and the Ar gas in the container 6 while maintaining the outside of the container 6 at a high degree of vacuum. Thus, a great number of neutral particle beams can be obtained.

The molecular velocity of the high speed fluid is preferably supersonic (5 > M > 1.2 where Mach value is denoted by M) or hypersonic (M > 5 where Mach value is denoted by M). The flowing sonic velocity $\underline{a}$ in the gas is given by:

$$a = (KRT)^{1/2}$$

where K: Ratio of specific heat; R: Gas constant; and T: Temperature.

In the case of the Ar gas:

when K = 1.658; R = 208.15; and T = 20 (K°);

approximately the following flowing velocities are required:

Supersonic     100 ~ 415 m/s

Hypersonic     > 415 m/s

As described above, the supersonic nozzle and the hypersonic nozzle can be fabricated by selecting proper shapes for the nozzles, proper gas pressures, etc.

By preparing nozzles for a wide range of flowing velocity, it is possible to select a gas fluid velocity which matches the energy (velocity) of a variety of charged particle beams to be subjected to charge exchange. This enhances the controllability of the probability of the charge exchange of high energy particles, thus enabling a higher exchange efficiency.

The state of the free molecular flow of a high speed gas fluid is defined by:

$$Mean free path of gas (\lambda) / Representative dimension$$

$$of nozzle (L) > 1$$

$\lambda/L$ is known as Knudsen value; it is desirable for charge exchange that the high speed gas fluid is in the state of free molecular flow having a Knudsen value of 1 or more.

$$Mean free path\ \lambda = 2.3\ x\ 10^{-20}\ T/Pa^2\ (cm)$$

where T: Temperature (°K); P: Pressure (Torr); a: Diameter of molecule (cm). Therefore, the Ar gas is put in the state of free molecular flow if

$$\lambda > 34\ (cm)$$

when T = 20 (°K); P = 1 x $10^{-5}$ (Torr); and a = 3.67 x $10^{-8}$ (cm).

Unlike the gas introduction method in a conventional charge exchanging gas cell, the beam charge exchanging apparatus according to this embodiment makes it possible to enlarge the holes through which charged particles pass without deteriorating the vacuum degree outside the gas container than that in a conventional apparatus by using a nozzle. This enables more neutral particle beams to be obtained with higher efficiency than in the conventional apparatus. This is achieved by selecting a nozzle of a proper size, so that the velocity of a fluid emitted through the nozzle has very little velocity component in the direction of a hole through which beams pass.

Further, since the high speed fluid from the nozzle causes adiabatic expansion of gas, it is possible to obtain a high speed fluid with a higher density, i.e., a high speed fluid having more particles, than that in a gas cell container of the same pressure, thus permitting improved probability of charge exchange. Such a high speed fluid allows a sufficiently large difference in pressure to be made between the inside and outside of the gas container, i.e. between the gas container and the vacuum container. In other words, a large volume of gas can be introduced in the gas container without impairing the vacuum outside the container. The gas in the gas container which has been used for charge exchange is exhausted by a vacuum pump for the gas container or it is circulated for reuse, thus preventing the gas from diffusing to the vacuum container of the whole beam system.

In the conventional charge exchanging apparatus, since the gas or metallic vapor in the gas container has a random velocity component it diffuses through holes in the container through which a beam passes; and therefore, adversely affects the pressure in the vacuum container. The apparatus of this embodiment is capable of achieving highly efficient charge exchange, enabling a large quantity of beams to be obtained. The apparatus is especially useful for the charge exchange of high energy charged particles and it becomes possible to neutralize a beam of about a few MeV, which used to be difficult in the past. Moreover, it is also possible to reduce the size of the nozzle and make the charge exchanging apparatus smaller accordingly.

The description given above refers to a high speed gas fluid employing Ar gas or the like, however, the high speed gas fluid may be composed of a metallic vapor such as Na, Ka, and Cs or a liquid such as a liquid nitrogen. Use of a variety of types of high speed fluids makes it possible to carry out the charge exchange process of charged particle beams of a variety of elements and energy values. Thus, embodiments of various modifications can be achieved without departing from the gist of the present invention.

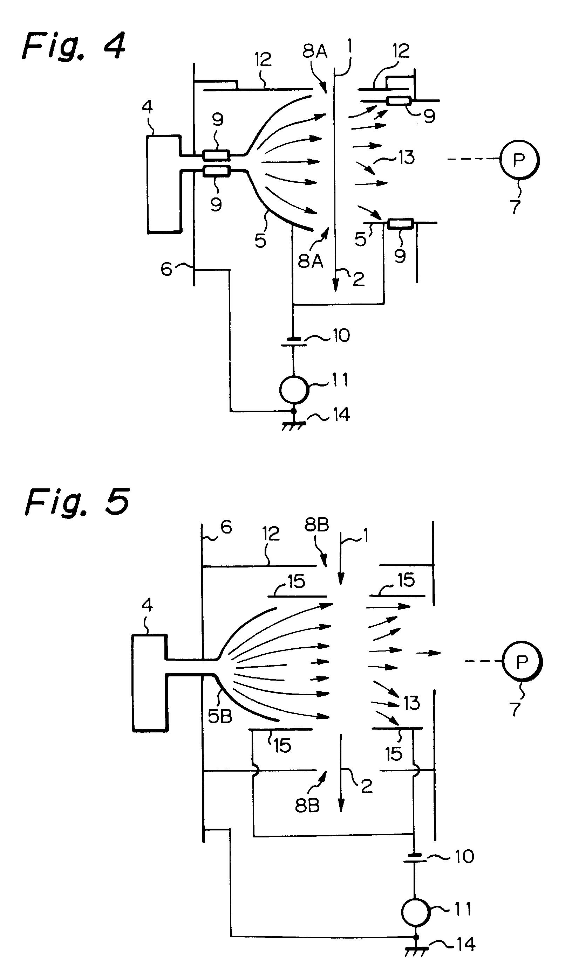

Figs. 4 through 6 show a fourth through sixth embodiments of a beam charge exchanging apparatus to which the present invention is applied. In the figures, the same reference numerals used in Figs. 1 to 3 denote the same or corresponding components. In the drawings, reference numeral 9 denotes an insulator composed of ceramic or the like to make the potential of the nozzle 5 electrically independent from the gas container 6; reference numeral 10 denotes a bias power supply which provides potential to an ion capturing electrode such as a divergent nozzle 5 or the like to electrostatically catch an ionized gas 13 thereon; reference numeral 11 denotes an ammeter for measuring ion current flowing into the divergent nozzle 5; and reference numeral 12 denotes a shielding plate for preventing the measurement of false current caused by the charged particle beam 1 before undergoing the charge exchange when it is irradiated to the nozzle 5. Reference numeral 14 denotes an ordinary ground which is connected to the gas container 6.

Fig. 4 shows the gas divergent nozzle 5 which has, at the middle thereof, holes 8A through which the beams 1 and 2 pass. This structure allows the charged particle (ion) beam 1 to pass through a gas fluid 3 from the gas reservoir tank 4 which has been expanded and accelerated via the gas nozzle 5 so as to exchange the charge thereof and turn the charged particle beam 1 into the neutral particle beam 2.

Fig. 5 shows the gas fluid provided as a free jet in the container 6 through a nozzle 5B of the gas reservoir tank 4. Reference numeral 15 denotes an electrode for capturing the gas which has ionized at a location other than the nozzle 5. Holes 8B through which the beams 1 and 2 pass are provided on the top and bottom surfaces of the container 6 and the electrode 15. This structure allows the charged particle (ion) beam 1 to pass through the holes 8B of the container 6 and go through the high speed gas fluid, which is supplied as the free jet from a nozzle 5B of the gas reservoir tank 4 so as to exchange the charge and turn the charged particle beam 1 into the neutral particle beam 2.

The apparatus shown in Fig. 6 has the gas divergent nozzle 5 provided in the container 6; charge exchange is performed between the gas fluid, which has been expanded and accelerated, and the charged particle beam 1, which enters through the hole 8C of the container 6 and produce the neutral particle beam 2 which exits through another hole 8C. Reference numeral 17 indicates an electrode which is electrically insulated from the gas nozzle 5 and which, by applying potential from the power supply 10, captures the ionized gas 13. The ion capturing electrode 17 may be shaped like bar(s).

The ion capturing electrode 17 positioned in the high speed fluid 3 causes vortex flows of the fluid behind the bar or bars constituting the electrode and the vortex flows interact thereby creating a density gradient in the high speed fluid 3. Thus, a high density portion of the fluid may be created in the area where the charged particle beam 1 passes through which enables still effective charge exchange to be performed.

The construction and operation of the embodiments shown in Figs. 4 to 6 are similar to those of the embodiments shown in Figs. 1 to 3 in the point that the charge exchange is effectively performed between the ion beam or charged particle beam 1 and high speed fluid 3 within the gas container 6 or the nozzle 5 by passing the charged particle beam 1 through the high speed fluid 3. However, the former is different from the latter in the point that, in the former, further the ionized gas generated through the charge exchange is captured on the electrode or the nozzle and the quantity of the captured ionized gas is measured as an electric current to determine the quantity of the neutral particles generated through the charge exchange. This will be explained in more detail.

For instance, by passing the ion beam 1 through the high speed gas fluid 3 constituted by Ar gas, the high speed gas removes the charge from the ion beam (charged particle) 1 to change it into the neutral particle beam 2. At this time, some Ar particles in the high speed gas fluid 3 are charged (ionized) to provide the $Ar^+$ gas 13. In the embodiments shown in Figs. 4 through 6, the ionized $Ar^+$ gas 13 for example has an electron energy (eV) of about 0.06 eV; therefore, a bias voltage of approximately -1 V which is applied to the nozzle 5 or the ion capturing electrodes 15 and 17 is sufficiently high to catch the ionized gas 13.

The voltage applied to the nozzle 5 or the ion capturing electrodes 15 and 17, however, may be 50 V or more, considering that the energy generated when the ionized gas is separated is about a few eV and the electron energy generated when the gas collides with ions ranges from about 5 to 30 eV.

The gas 13 which has ionized in the high speed gas fluid 3 is captured by the divergent nozzle electrode 5 in the embodiment shown in Fig. 4 or by the capturing electrode 15 in the embodiment shown in Fig. 5 or by the capturing electrode 17 in the embodiment shown in Fig. 6 by the bias voltage supplied to the electrodes from the power supply 10. When the ionized gas 13 is captured by the electrode 5, 15, or 17, current flows through the ground 14 and the current is measured by the ammeter 11, thereby permitting the measurement of the quantity of the charge of the ionized gas 13. The quantity of the charge of the ionized gas 13 is equal to the quantity of the charge of the beam of the neutral particle beam 2 changed from the charged particle beam 1 by the high speed gas fluid 3; therefore, the current measured by the ammeter 11 is proportional to the quantity of the neutral particles obtained by the charge exchange.

Hence, the neutral particle beam is electrically neutral and it was impossible to electrically measure the quantity of neutral particles in the past. According to the apparatuses of the invention, however, efficient charge exchange and the measurement of the quantity of neutral particles become possible.

According to the present invention, a smaller apparatus can be achieved, which is capable of charge-exchanging a large quantity of beams at high efficiency and which is capable of preventing the deterioration of the vacuum degree outside the charge-exchanging apparatus. The apparatus is also capable of neutralizing especially high energy charged particle (ion) beams and it is also applicable to beams of about a few MeV.

In addition, according to the present invention, a smaller apparatus can be achieved, which is capable of charge-exchanging a large quantity of beams with high efficiency while preventing the deterioration of the vacuum degree outside the charge exchanging apparatus and also capable of monitoring the quantity of neutral particles resulting from the charge exchange.

Further, according to the charge exchanging apparatus of the present invention, a large quantity of electrically neutral particle beams can be obtained and the quantity of neutral particles can be measured. Hence, a predetermined quantity of neutral particles can be implanted, for example, in place of ions in an ion implantation art in implanting an impurity into a semiconductor. The use of neutral particles solves the problem of charging-up which takes place when implanting an impurity into, for example, an insulation film. In addition, since precise irradiation control, which is an advantage of an ion implanting apparatus, can be accomplished by monitoring the quantity of neutral particles produced by charge exchange, a significant industrial advantage is expected.

## Claims

1. A beam charge exchanging apparatus comprising:

   a container (6) disposed in a vacuum, said container (6) having an entrance hole (8) through which a particle beam (1) is to be introduced, and an exit hole (8) from which a beam (1) leaves the container (6); and
   fluid introduction means for introducing fluid (3) into said container as a flow having a molecular velocity M of greater than 1.2, wherein M is Mach value, and in a direction the velocity vector of which is not directed toward the entrance and exit holes (8) of the container (6) but which will intersect the particle beam (1) introduced into the container (6) through said entrance hole, whereby the fluid (3) will collide with the particle beam (1) to exchange charges therewith,
   said fluid introduction means comprising a pressurized fluid reservoir (4) , and a divergent nozzle (5) which is connected to and diverges in a direction away from said reservoir (4).

2. A beam charge exchanging apparatus as claimed in Claim 1, wherein said fluid introduction means introduces the fluid (3) into said container (6) as a flow having a molecular velocity M of greater than 1.2 and less than 5, such that the molecular velocity of the stream is supersonic.

3. A beam charge exchanging apparatus as claimed in Claim 1, wherein said fluid introduction means introduces the fluid (3) into said container (6) as a flow having a molecular velocity M of greater than 5, such that the molecular velocity of the stream is hypersonic.

4. A beam charge exchanging apparatus as claimed in any one of the preceding claims, wherein said fluid introduction means introduces the fluid (3) into said container (6) as a stream having a free molecular flow.

5. A beam charge exchanging apparatus as claimed in any one of the preceding claims, wherein said fluid introduction means introduces a liquid into said container (6).

6. A beam charge exchanging apparatus as claimed in any one of Claims 1-4, wherein said fluid introduction means introduces a metallic vapor into said container (6).

7. A beam charge exchanging apparatus as claimed in any one of the preceding Claims, and further comprising a pump (7) for discharging the fluid (3) from said container (6) after the fluid has collided with and exchanged charges with the particle beam (1).

8.  A beam charge exchanging apparatus as claimed in any one of the preceding claims, and further comprising:

    detecting means (15) for detecting a quantity of neutral particles resulting from the exchange of charges by measuring the quantity of ionized fluid generated by said exchange as an electric current.

9.  A beam charge exchanging apparatus as claimed in Claim 8, wherein said divergent nozzle (5) has openings therethrough located within said container (6), and said detecting means (15) comprises a bias power supply (10) connected to said nozzle (5) so as to provide a potential thereto, whereby the nozzle (5) becomes an electrode that will attract ionized fluid, and an ammeter (11) connected to said nozzle (5).

10. A beam charge exchanging apparatus as claimed in Claim 8, wherein said nozzle (5) has an end open within said container (6), and said detecting means comprises an electrode (17) disposed within said end of said nozzle (5), a bias power supply (10) connected to said electrode (17) so as to provide a potential thereto, whereby the electrode (17) will attract ionized fluid, and an ammeter (11) connected to said electrode (17).

11. A beam charge exchanging apparatus as claimed in Claim 9 or 10, and further comprising a shield (12) disposed between the entrance hole (8) of said container (6) and the electrode (5;17) so as to shield the electrode (5;17) from the particle beam (1) and thereby prevent a false measurement by said detection means (15).

**Patentansprüche**

1.  Strahlladungsaustauschvorrichtung die folgendes aufweist:

    einen in einem Vakuum angeordneten Behälter (6) der ein Eintrittsloch (8) aufweist, durch den ein Teilchenstrahl (1) einführbar ist und der ferner ein Austrittsloch (8) aufweist aus dem ein Strahl (1) den Behälter (6) verläßt; und
    Strömungsmitteleinführmittel zum Einführen von Strömungsmittel (3) in den Behälter als eine Strömung mit einer Molekulargschwindigkeit M größer als 1,2, wobei M ein Machwert ist, und in einer Richtung, wobei der Geschwindigkeitsvektor nicht zu den Eintritts- und Austrittslöchern (8) des Behälters (6) hingerichtet ist sondern den durch das Eintrittsloch in den Behälter (6) eingeführten Teilchenstrahl schneidet, wodurch das Strömungsmittel mit dem Teilchenstrahl (1) zum Austausch von Ladung damit kollidiert, wobei die Strömungsmitteleinführmittel ein unter Druck stehendes Strömungsmittelreservoir (4) aufweisen und eine divergente Düse (5), die mit dem Reservoir (4) verbunden ist und von dem Reservoir in einer Richtung weg von diesem divergiert.

2.  Strahlladungsaustauschvorrichtung nach Anspruch 1, wobei die Strömungsmitteleinführmittel das Strömungsmittel (3) in den Behälter (6) als eine Strömung mit einer Molekulargeschwindigkeit M größer als 1,2 und kleiner als 5 derart einführen, daß die Molekulargeschwindigkeit des Stromes supersonisch ist.

3.  Strahlladungsaustauschvorrichtung nach Anspruch 1, wobei die Strömungsmitteleinführmittel das Strömungsmittel (3) in den Behälter (6) als eine Strömung mit einer Molekulargeschwindigkeit M von größer als 5 derart einführen, daß die Molekulargeschwindigkeit des Stromes hypersonisch ist.

4.  Strahlladungsaustauschvorrichtung nach einem der vorhergehenden Ansprüche, wobei die Strömungsmitteleinführmittel das Strömungsmittel (3) in dem Behälter (6) als einen Strom mit einem frei molekularen Strom einführen.

5.  Strahlladungsaustauschvorrichtung nach einem oder mehreren der vorhergehenden Ansprüche, wobei die Strömungsmitteleinführmittel eine Flüssigkeit in dem Behälter (6) einführen.

6.  Strahlladungsaustauschvorrichtung nach einem der Ansprüche 1 bis 4, wobei die Strömungsmitteleinführmittel einen Metalldampf in den Behälter (6) einführen.

7.  Strahlladungsaustauschvorrichtung nach einem der vorhergehenden Ansprüche, wobei ferner eine Pumpe (7) vorgesehen ist, zum Abgeben des Strömungsmittels (3) vom Behälter (6) nachdem das Strömungsmittel kollidiert hat und Ladungen mit dem Teilchenstrahl (1) ausgetauscht hat.

8.  Strahlladungsaustauschvorrichtung nach einem der vorhergehenden Ansprüche, und wobei ferner Detektormittel (15) vorgesehen sind, zum Detektieren einer Menge an neutralen Teilchen, die sich aus dem Ladungsaustausch ergeben, und zwar durch Messen der Menge an ionisiertem Strömungsmittel erzeugt durch den Austausch als einen elektrischen Strom.

9. Strahlladungsaustauschvorrichtung nach Anspruch 8, wobei die erwähnte divergente Düse (5) hindurchgehend innerhalb des Behälters (6) angeordnete Öffnungen aufweist, und wobei die Detektiermittel (15) eine Vorspannleistungsversorgung (10) verbunden mit der Düse (5) aufweisen, um so daran ein Potential vorzusehen, wodurch die Düse (5) eine Elektrode wird, die ionisiertes Strömungsmittel anzieht, und wobei ferner ein Amperemeter (11) mit der Düse (5) in Verbindung steht.

10. Strahlladungsaustauschvorrichtung nach Anspruch 8, wobei die Düse (5) ein offenes Ende innerhalb des Behälters (6) aufweist und wobei die Detektormittel eine Elektrode (17) angeordnet in dem erwähnten Ende der Düse (5) aufweisen, ferner eine Vorspannleistungsversorgung (10) verbunden mit der Elektrode (17) um so ein Potential daran vorzusehen, wodurch die Elektrode (17) ionisiertes Strömungsmittel anziehen wird, und wobei ferner ein Amperemeter (11) mit der Elektrode (17) in Verbindung steht.

11. Strahlladungsaustauschvorrichtung nach Anspruch 9 oder 10, und wobei ferner eine Abschirmung (12) zwischen dem Eingangs- oder Eintrittsloch (8) des Behälters (6) und der Elektrode (5; 17) derart angeordnet ist, um die Elektrode (5; 17) von dem Teilchenstrahl (1) abzuschirmen, und dadurch eine Falschmessung durch die Detektormittel (15) zu verhindern.

**Revendications**

1. Appareil d'échange de charge de faisceau comportant:

   un réservoir (6) placé dans une enceinte à vide, ledit réservoir (6) comportant un trou d'entrée (8) par lequel un faisceau de particules (1) doit être introduit et un trou de sortie (8) par lequel un faisceau (1) quitte le réservoir (6); et
   un moyen d'introduction de fluide pour introduire un fluide (3) dans ledit réservoir sous forme d'un flux de vitesse moléculaire M de valeur supérieure à 1,2, où M est la valeur du Mach, et dans une direction pour laquelle le vecteur de vitesse n'est pas dirigé vers les trous d'entrée et de sortie (8) du réservoir (6) mais qui coupe le faisceau de particules (1) introduit dans le réservoir (6) par ledit trou d'entrée, ce par quoi le fluide (3) entre en collision avec le faisceau de particules (1) pour échanger des charges avec lui,
   ledit moyen d'introduction de fluide comportant une cuve de fluide sous pression (4) et une buse divergente (5) reliée à ladite cuve (4) à partir de laquelle elle diverge vers l'extérieur.

2. Appareil d'échange de charge de faisceau selon la revendication 1, dans lequel ledit moyen d'introduction de fluide introduit le fluide (3) dans ledit réservoir (6) sous forme d'un flux de vitesse moléculaire M comprise entre 1,2 et 5, de façon à ce que la vitesse moléculaire du jet soit supersonique.

3. Appareil d'échange de charge de faisceau selon la revendication 1, dans lequel ledit moyen d'introduction de fluide introduit le fluide (3) dans ledit réservoir (6) sous forme d'un flux de vitesse moléculaire M supérieure à 5, de façon à ce que la vitesse moléculaire du jet soit hypersonique.

4. Appareil d'échange de charge de faisceau selon l'une quelconque des revendications précédentes, dans lequel ledit moyen d'introduction de fluide introduit le fluide (3) dans ledit réservoir (6) sous forme de jet de flux moléculaire libre.

5. Appareil d'échange de charge de faisceau selon l'une quelconque des revendications précédentes, dans lequel ledit moyen d'introduction de fluide introduit un liquide dans ledit réservoir (6).

6. Appareil d'échange de charge de faisceau selon l'une quelconque des revendications précédentes 1 à 4, dans lequel ledit moyen d'introduction de fluide introduit une vapeur métallique dans ledit réservoir (6).

7. Appareil d'échange de charge de faisceau selon l'une quelconque des revendications précédentes et comportant en outre une pompe (7) pour évacuer le fluide (3) hors dudit réservoir (6) après la collision du fluide avec le faisceau de particules (1) et l'échange de charges avec celui-ci.

EP 0 663 671 B1

8. Appareil d'échange de charge de faisceau selon l'une quelconque des revendications précédentes et comportant en outre:

un moyen de détection (15) pour détecter une quantité de particules neutres résultant de l'échange de charges en mesurant la quantité de fluide ionisé généré par ledit échange sous forme de courant électrique.

9. Appareil d'échange de charge de faisceau selon la revendication 8, dans lequel des ouvertures ont été percées dans ladite buse divergente (5) placé à l'intérieur dudit réservoir (6) et ledit moyen de détection (15) comporte une alimentation de polarisation (10) connectée à ladite buse (5) de façon à lui fournir un potentiel, ce par quoi la buse (5) devient une électrode qui va attirer le fluide ionisé, et un ampèremètre (11) connecté à ladite buse (5).

10. Appareil d'échange de charge de faisceau selon la revendication 8, dans lequel ladite buse (5) comporte à une extrémité une ouverture se trouvant à l'intérieur dudit réservoir (6), et ledit moyen de détection comporte une électrode (17) placée à l'intérieur de ladite extrémité de ladite buse (5), une alimentation de polarisation (10) connectée à ladite électrode (17) de façon à lui fournir un potentiel, ce par quoi l'électrode va attirer le fluide ionisé, et un ampèremètre (11) connecté à ladite électrode (17).

11. Appareil d'échange de charge de faisceau selon la revendication 9 ou 10 et comportant en outre un blindage (12) placé entre le trou d'entrée (8) dudit réservoir (6) et l'électrode (5; 17) de façon à blinder l'électrode (5; 17) pour la protéger contre le faisceau de particules (1) et empêcher ainsi que ledit moyen de détection (15) n'effectue une fausse mesure.

Fig. 1

Fig. 2

Fig. 3

Fig. 4

Fig. 5

# Fig. 6

# Fig. 7